# EUROPEAN PATENT SPECIFICATION

(11) **EP 3 903 390 B1**
(45) Date of publication and mention of the grant of the patent: **30.11.2022**
(21) Application number: 19722898.4
(22) Date of filing: 08.05.2019
(51) Int. Cl.: H01S 5/026

(54) **COMPOUND OPTICAL DEVICE**
ZUSAMMENGESETZTE OPTISCHE VORRICHTUNG
DISPOSITIF OPTIQUE COMPOSITE

(43) Date of publication of application: 03.11.2021
(73) Proprietor: Huawei Technologies Co., Ltd., Longgang District, Shenzhen, Guangdong 518129, (CN)
(72) Inventor: CHEN, Xin, 80992 Munich (DE)
(74) Representative: Maiwald GmbH
(86) International application number: PCT/EP2019/061841
(87) International publication number: WO 2020/224775

(56) References cited:
- GB-A- 2 292 011
- US-A1- 2002 158 266
- US-A1- 2003 146 440
- US-A1- 2013 272 326
- US-B2- 7 733 934
- US-B2- 9 160 139

## Description

This invention relates to a compound optical device.

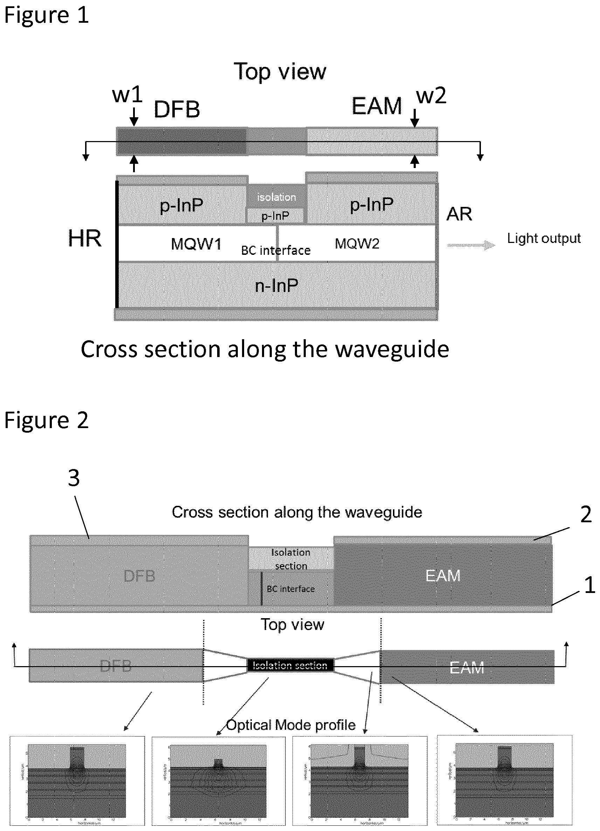

Some optical devices are formed with adjoining material portions, with the interface between the portions being discontinuous: for example in its crystalline structure. For example, one form of electroabsorption modulated laser (EML) comprises adjoining blocks of multi-quantum well (MQW) materials: one block forming part of a distributed feedback (DFB) laser and one block forming part of an electroabsorption modulator (EAM). This structure is shown in figure 1. The upper portion of figure 1 shows a top view of an EML device. The lower portion of figure 1 shows a cross-section of the EML device. One MQW block is designated MQW1. The other MQW block is designated MQW2. A highly reflective end facet is designated HR. A substantially unreflective or anti-reflective facet is designated AR. The MQW blocks MQW1 and MQW2 are formed in separate steps. For example, one may be integral with the substrate (e.g. the n-lnP region) whereas the other may be subsequently grown on that substrate. This technique is known as butt coupling (BC). This process can lead to a crystalline discontinuity between the blocks MQW1 and MQW2, at the butt-coupled interface (designated BC interface in figure 1).

A waveguide is defined in the EML for guiding laser light in the device. Conventionally, the laser waveguide is of constant width, w1, and the modulator waveguide is constant width, w2, as shown in the top view of figure 1.

The discontinuity between the two adjoining MQW blocks can be a cause of weakness and failure in the EML device. It is known that the BC process is very critical for reliable operation. Light emitted from the DFB laser section is absorbed exponentially along the EAM waveguide, so the greatest absorption is in the region closest to the laser. This can result in a temperature profile that is strongly peaked at the EAM input section. This can cause breakdown of the device at the BC interface.

One approach to mitigate this problem is to optimize the butt-coupling process to increase the resilience of the BC joint. Further, it has been proposed to use a sectioned waveguide so the absorption profile is divided into low-absorption and high-absorption segments that are distributed axially in order to decrease the maximum local temperature in the device. The distribution of low absorption segments can be controlled through techniques such as proton implantation or selective-area quantum well intermixing. These techniques are difficult to implement and not currently suitable for mass production.

United States patent application US 2003/0146440 A1 discloses a semiconductor optical integrated device comprising a light-emitting element portion, a modulation element portion, and a separation portion on a substrate.

United States patent US 9,160,139 B2 discloses a laser emission device with integrated light modulator comprising a multilayer waveguide with a laser amplification section, a light modulation section and a transition section inserted between the laser amplification section and the light modulation section. There is a need to improve the reliability of devices of the type shown in figure 1 and other optical devices having similar problems, and to reduce the need for such highly precise control of the BC process.

According to one aspect of the invention there is provided a compound laser structure as defined in appending independent claim 1.

According to a second aspect of the invention there is provided a method of forming a compound laser structure as defined in appending independent method claim 14.

Preferred embodiments are disclosed in the dependent claims.

The laser emitter may have a first end further from the modulator and a second end closer to the modulator and the laser emitter may be configured so that its cross section tapers towards the modulator in the region of the second end. This can reduce optical intensity in certain parts of the device in the region of the intermediate location.

The modulator may have a first end further from the laser emitter and a second end closer to the laser emitter and the modulator is configured so that its cross section tapers towards the laser emitter in the region of the second end. This can reduce optical intensity in certain parts of the device in the region of the intermediate location. The taper in the modulator may be longer than the taper in the laser emitter. This can improve performance.

The waveguide may comprise an electrical isolation region extending between the laser emitter and the modulator. This can electrically separate the emitter and the modulator.

The laser emitter and the modulator may be defined on a face (e.g. a planar face) of the substrate. The waveguide may be configured so that its width in a direction perpendicular to the coupling axis and parallel with the planar face of the substrate tapers so as to be smaller at the intermediate location than at locations on either side of the intermediate location along the coupling axis. This can reduce optical intensity in certain parts of the device in at the intermediate location.

The laser emitter and the modulator are defined on a planar face of the substrate and the waveguide is configured so that its height in a direction perpendicular to the planar face of the substrate tapers so as to be smaller at the intermediate location than at locations on either side of the intermediate location along the coupling axis. This can reduce optical intensity in certain parts of the device in at the intermediate location.

The tapered waveguide may be operative to, when the laser structure is in operation, promote, in a region of the structure axially coincident with the intermediate location, the propagation in the substrate of an optical mode of light travelling in the waveguide. This can result in a consequent reduction in the intensity of an optical mode in adjacent part of the device.

The waveguide may taper monotonically to the intermediate location. This can improve efficiency. The taper may be linear. The taper may be substantially or wholly an adiabatic taper.

The laser emitter may be a distributed feedback laser. The optical modulator may be configurable under the action of an applied electrical field to select its frequency response. The optical modulator may be an electroabsorption modulator.

There may be a crystalline interface between at least part of the laser emitter and the optical modulator, the crystalline interface being located within 100µm of the intermediate location in a direction along the coupling axis. This interface may be protected by the measures set out herein.

The interface may be a butt-coupled interface.

The present invention will now be described by way of example with reference to the accompanying drawings.

In the drawings:
Figure 1 shows an example of a conventional EML.
Figure 2 shows an example of an alternative design of EML.

Figure 2 shows an electroabsorption modulated laser (EML). The upper part of figure 2 shows a cross-section through the device on its longitudinal (length) and vertical (height) axes. The central part of figure 2 shows a top view of the device on its longitudinal and width axes. The lower part of figure 2 shows the profile of the optical mode in the device at four regions indicated by arrows from the central part of figure 2. Conveniently, the length axis is orthogonal to the end faces. It will be appreciated that the axes of the device are defined for convenience of description and the device could operate in any physical attitude.

The EML device comprises a DFB laser which abuts an EAM. A highly reflective facet is provided on the longitudinal end surface closer to the DFB laser. That facet may be provided with a reflective coating. A substantially non-reflective facet is provided on the longitudinal end surface closer to the EAM. That facet may be provided with an anti-reflective coating. In operation the device emits light through the end surface closer to the EAM. The facets may be formed by cleaving.

A continuous electrode layer 1 is provided on the lower face of the device. Separate electrode layers 2, 3 are provided on the upper surface of the device, for driving the EAM and the DFB laser respectively.

The DFB laser comprises multiple layers of suitably doped semiconductor material. As indicated in figure 1, in one example it may comprise an n-lnP layer between the MQW layer of the DFB and the lower electrode 1 and a p-lnP layer between the MQW layer and the upper electrode 3.

The EAM comprises multiple layers of suitably doped semiconductor material. As indicated in figure 1, in one example it may comprise an n-lnP layer between the MQW layer of the EAM and the lower electrode 1 and a p-lnP layer between the MQW layer and the upper electrode 2. The lower n-lnP layer of the EAM may be integral with the lower n-lnP layer of the DFB. For clarity the lower n-lnP layer is not separately shown in figure 2.

The MQW regions are formed of different materials. This can conveniently be done by forming one of those regions integrally with the wafer substrate on which the device is constructed, and then overgrowing the other of the MQW regions on the substrate. A part of the first-formed MQW region may be etched away after it has been formed, to make space for the second MQW region to occupy. Conveniently it may be the MQW region of the EAM that is formed by overgrowing. Alternatively, both MQW regions may be overgrown separately on the wafer substrate. These processes result in a butt-coupled interface between the MQW regions. In either forming method, there is the possibility of a crystalline discontinuity between the MQW regions due, for example, to a difference in lattice parameters or crystalline orientations between the two regions or due to surface imperfections at the interface prior to the final overgrowing step. This discontinuity can result in faults in the device during use, for example arising from the build-up of heat at the BC interface.

An isolation section is located between the upper parts of the DFB and the EAM. One purpose of the isolation section is to electrically isolate the upper electrodes 2 and 3. The isolation section is formed of a dielectric. The BC joint underlies the isolation section. The DFB and EAM can be electrically isolated via etching-away the top p-doped (as in a device doped as shown in figure 1) or n-doped layers or by ion-implantation.

As shown in figure 1, a further doped semiconductor region can be located between the isolation section and the MQW regions, overlying the BC joint. That region may, for example, be a p-lnP doped region. For clarity that upper p-lnP layer in the region of the isolation section is not separately shown in figure 2.

In the device of figure 2, the profile of the waveguide in plan (see the middle part of figure 2) is such that the waveguide has non-constant width in the region of the isolation section. The waveguide has a relatively narrow region coincident with the BC interface. The relatively narrow region may be localised to the BC interface or, as shown in figure 2, it may extend on either side of the BC interface. For example, it may extend for the length of the isolation section. Alternatively, it may extend for part of the length of the isolation section. The relatively narrow region may be of constant width. The relatively narrow region may end at the interfaces between the isolation section and the DFB and the EAM. The relatively narrow region may be the narrowest region of the entire waveguide. The term "narrow" indicates a relatively small width: i.e. in a direction perpendicular to the longitudinal axis of the device and to one or both of the upper surface of the device's substrate or to the upper or lower surfaces of one or more layers of the device.

On either side of the relatively narrow region the profile of the waveguide in plan tapers in a direction from the respective end of the device to the boundary with the relatively narrow region. Conveniently, the taper can be constituted by a deviation of both exterior surfaces of the waveguide from being parallel with the longitudinal axis of the device. Put another way, the device may taper on both sides. Alternatively, it may taper on only one side. Conveniently the taper is linear, but it may be curved. On the DFB side of the device, the taper extends from a full-width region of the DFB part of the waveguide to the relatively narrow region. The full-width region may extend with constant width from its boundary with the tapered section to the face of the device at the longitudinal end of the DFB. On the EAM side of the device, the taper extends from a full-width region of the EAM part of the waveguide to the relatively narrow region. The full-width region may extend with constant width from its boundary with the tapered section to the face of the device at the longitudinal end of the EAM. The tapered portions may be defined partly, or exclusively, in the regions of the DFB and the EAM underlying the upper electrodes 2, 3.

The width of the waveguide at the BC interface, and optionally in regions on either side of it, may be less than the average width of the waveguide in the active part of the DFB. The active part of the DFB may be the part between the DFB's electrodes. The width of the waveguide at the BC interface, and optionally in regions on either side of it, may be less than the average width of the waveguide in the active part of the EAM. The active part of the EAM may be the part between the EAM's electrodes. The lower part of figure 2 illustrates the effect of this configuration. In the region of the BC interface the optical mode tends to be pushed into the lower region of the device (the region designated n-lnP in figure 1). This results in a weakening of the optical mode in the region of the BC interface compared to an analogous device of constant width. An effect of this is that light intensity and heating at the BC interface can be reduced, leading to improved device reliability. Furthermore, it can be anticipated that light absorption will be more even along the EAM waveguide, resulting in reduced saturation, higher optical output power and better performance.

Instead of or in addition to the width of the waveguide tapering towards the BC interface, its height tapers towards the BC interface.

In one convenient mass production technique, a stepper can be used to provide waveguide ridge control.

As is well-known, the DFB may comprise a grating. That may be a full, λ/4 or partial grating.

The waveguide for the DFB can be a buried heterostructure (BH) or ridge (e.g. shallow ridge) waveguide. The waveguide for the EAM can be a BH, shallow etched or deep etched waveguide.

The dimensions of the device can be selected to suit the desired operating parameters. For example, the DFB waveguide width can be from 1.5 µm to 3.0 µm. The length of the taper at the DFB end can be up to 25 µm. Conveniently, the taper may occupy up to 25 µm of the length of the DFB at its end closer to the BC interface. The narrowing/tapering in the DFB waveguide may be adiabatical in form.

The EAM waveguide width can be from 0.8 µm to 3.0 µm. The length of the taper at the EAM end can be up to from 10 to 50 µm. Conveniently, the taper may occupy up to 50 µm of the length of the EAM at its end closer to the BC interface. The narrowing/tapering in the EAM waveguide may be adiabatical in form.

The width of the waveguide in the isolation region can be constant, or there may be a tapering - preferably adiabatical - in the isolation section on one or both sides of (and towards) the BC interface. At its narrowest the width of the waveguide in the isolation region may be from 0.80 µm to 1.5 µm. Optionally, in the part(s) of the isolation region closest to one or both of the DFB and the EAM, e.g. for up to 20 µm in length, the waveguide width may widen linearly or adiabatically towards the EAM/DFB sections respectively.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein, and without limitation to the scope of the claims. The applicant indicates that aspects of the present invention may consist of any such individual feature or combination of features. In view of the foregoing description it will be evident to a person skilled in the art that various modifications may be made within the scope of the invention as defined by the appended independent claims.

## Claims

1. A compound laser structure comprising:
a substrate; and
an active waveguide structure comprising a laser emitter defined on a first area of the substrate and an optical modulator defined on a second area of the substrate, the modulator being optically coupled to the laser emitter along a coupling axis;
wherein the active waveguide structure is configured so that its cross-section perpendicular to the coupling axis tapers so as to be smaller at an intermediate location between the laser emitter and the optical modulator than at locations on either side of the intermediate location along the coupling axis,
wherein the laser emitter and the modulator are defined on a planar face of the substrate
**characterized in that** the active waveguide is configured so that its height in a direction perpendicular to the planar face of the substrate tapers so as to be smaller at the intermediate location than at locations on either side of the intermediate location along the coupling axis.

2. A compound laser structure as claimed in claim 1, wherein the laser emitter has a first end further from the modulator and a second end closer to the modulator and the laser emitter is configured so that its cross section tapers towards the modulator in the region of the second end.

3. A compound laser structure as claimed in claim 1 or 2, wherein the modulator has a first end further from the laser emitter and a second end closer to the laser emitter and the modulator is configured so that its cross section tapers towards the laser emitter in the region of the second end.

4. A compound laser structure as claimed in claim 3 as dependent on claim 2, wherein the taper in the modulator is longer than the taper in the laser emitter.

5. A compound laser structure as claimed in any preceding claim, wherein the waveguide comprises an electrical isolation region extending between the laser emitter and the modulator.

6. A compound laser structure as claimed in any preceding claim, wherein the waveguide is configured so that its width in a direction perpendicular to the coupling axis and parallel with the planar face of the substrate tapers so as to be smaller at the intermediate location than at locations on either side of the intermediate location along the coupling axis.

7. A compound laser structure as claimed in any preceding claim, wherein the tapered waveguide is operative to, when the laser structure is in operation, promote, in a region of the structure axially coincident with the intermediate location, the propagation in the substrate of an optical mode of light travelling in the waveguide.

8. A compound laser structure as claimed in any preceding claim, wherein the waveguide tapers monotonically to the intermediate location.

9. A compound laser structure as claimed in any preceding claim, wherein the laser emitter is a distributed feedback, DFB, laser.

10. A compound laser structure as claimed in any preceding claim, wherein the optical modulator is configurable under the action of an applied electrical field to select its frequency response.

11. A compound laser structure as claimed in any preceding claim, wherein the optical modulator is an electroabsorption modulator, EAM.

12. A compound laser structure as claimed in any preceding claim, comprising a crystalline interface between at least part of the laser emitter and the optical modulator, the crystalline interface being located within 100µm of the intermediate location in a direction along the coupling axis.

13. A compound laser structure as claimed in claim 12, wherein the crystalline interface is a butt-coupled interface.

14. A method of forming a compound laser structure, comprising:
forming a first one of a laser emitter and an optical modulator on a substrate; and
depositing the other of a laser emitter and an optical modulator on the substrate so as to be butt-coupled along a coupling axis to the first one of a laser emitter and an optical modulator, and so that the laser emitter and the optical modulator together at least partially define an active waveguide structure; the active waveguide structure being configured so that its cross-section perpendicular to the coupling axis tapers so as to be smaller at an intermediate location between the laser emitter and the optical modulator than at locations on either side of the intermediate location along the coupling axis,
wherein the laser emitter and the modulator are defined on a planar face of the substrate
**characterized in that** the waveguide is configured so that its height in a direction perpendicular to the planar face of the substrate tapers so as to be smaller at the intermediate location than at locations on either side of the intermediate location along the coupling axis.

## Patentansprüche

1. Verbundlaserstruktur, umfassend:
ein Substrat; und
eine aktive Wellenleiterstruktur, die einen auf einem ersten Bereich des Substrats definierten Laseremitter und einen auf einem zweiten Bereich des Substrats definierten optischen Modulator umfasst, wobei der Modulator entlang einer Kopplungsachse optisch mit dem Laseremitter gekoppelt ist;
wobei die aktive Wellenleiterstruktur derart konfiguriert ist, dass sich ihr Querschnitt senkrecht zu der Kopplungsachse verjüngt, so dass er an einer Zwischenposition zwischen dem Laseremitter und dem optischen Modulator kleiner ist als an Positionen auf jeder Seite der Zwischenposition entlang der Kopplungsachse,
wobei der Laseremitter und der Modulator auf einer ebenen Fläche des Substrats definiert sind,
**dadurch gekennzeichnet, dass**
der aktive Wellenleiter derart konfiguriert ist, dass sich seine Höhe in einer Richtung senkrecht zu der ebenen Fläche des Substrats derart verjüngt, dass sie an der Zwischenposition kleiner ist als an Positionen auf jeder Seite der Zwischenposition entlang der Kopplungsachse.

2. Verbundlaserstruktur nach Anspruch 1, wobei der Laseremitter ein erstes Ende weiter entfernt von dem Modulator und ein zweites Ende näher zu dem Modulator umfasst und der Laseremitter derart konfiguriert ist, dass sich sein Querschnitt hin zu dem Modulator in dem Gebiet des zweiten Endes verjüngt.

3. Verbundlaserstruktur nach Anspruch 1 oder 2, wobei der Modulator ein erstes Ende weiter entfernt von dem Laseremitter und ein zweites Ende näher zu dem Laseremitter umfasst und der Modulator derart konfiguriert ist, dass sich sein Querschnitt hin zu dem Laseremitter in dem Gebiet des zweiten Endes verjüngt.

4. Verbundlaserstruktur nach Anspruch 3, wenn abhängig von Anspruch 2, wobei die Verjüngung in dem Modulator länger ist als die Verjüngung in dem Laseremitter.

5. Verbundlaserstruktur nach einem der vorhergehenden Ansprüche, wobei der Wellenleiter ein elektrisches Isolationsgebiet umfasst, das sich zwischen dem Laseremitter und dem Modulator erstreckt.

6. Verbundlaserstruktur nach einem der vorhergehenden Ansprüche, wobei der Wellenleiter derart konfiguriert ist, dass sich seine Breite in einer Richtung senkrecht zu der Kopplungsachse und parallel zu der ebenen Fläche des Substrats derart verjüngt, dass sie an der Zwischenposition kleiner ist als an Positionen auf jeder Seite der Zwischenposition entlang der Kopplungsachse.

7. Verbundlaserstruktur nach einem der vorhergehenden Ansprüche, wobei der verjüngte Wellenleiter betreibbar ist, um, wenn die Laserstruktur in Betrieb ist, in einem Gebiet der Struktur, das axial mit der Zwischenposition koinzident ist, die Ausbreitung einer sich in dem Wellenleiter bewegenden optischen Lichtmode in dem Substrat zu fördern.

8. Verbundlaserstruktur nach einem der vorhergehenden Ansprüche, wobei sich der Wellenleiter gleichbleibend zu der Zwischenposition verjüngt.

9. Verbundlaserstruktur nach einem der vorhergehenden Ansprüche, wobei der Laseremitter ein Laser mit verteilter Rückführung, DFB, ist.

10. Verbundlaserstruktur nach einem der vorhergehenden Ansprüche, wobei der optische Modulator unter der Wirkung eines angelegten elektrischen Felds konfigurierbar ist, um seinen Frequenzgang auszuwählen.

11. Verbundlaserstruktur nach einem der vorhergehenden Ansprüche, wobei der optische Modulator ein Elektroabsorptionsmodulator, EAM, ist.

12. Verbundlaserstruktur nach einem der vorhergehenden Ansprüche, umfassend eine kristalline Schnittstelle zwischen zumindest einem Teil des Laseremitters und dem optischen Modulator, wobei sich die kristalline Schnittstelle innerhalb von 100 µm der Zwischenposition in einer Richtung entlang der Kopplungsachse befindet.

13. Verbundlaserstruktur nach Anspruch 12, wobei die kristalline Schnittstelle eine muffengekoppelte Schnittstelle ist.

14. Verfahren zum Ausbilden einer Verbundlaserstruktur, umfassend:
Ausbilden eines ersten eines Laseremitters und eines optischen Modulators auf einem Substrat; und
Ablagern des anderen des Laseremitters und des optischen Modulators auf dem Substrat derart, dass er entlang einer Kopplungsachse mit dem ersten eines Laseremitters und eines optischen Modulators muffengekoppelt ist, und derart, dass der Laseremitter und der optische Modulator zusammen zumindest teilweise eine aktive Wellenleiterstruktur definieren;
wobei die aktive Wellenleiterstruktur derart konfiguriert ist, dass sich ihr Querschnitt senkrecht zu der Kopplungsachse verjüngt, so dass er an einer Zwischenposition zwischen dem Laseremitter und dem optischen Modulator kleiner ist als an Positionen auf jeder Seite der Zwischenposition entlang der Kopplungsachse,
wobei der Laseremitter und der Modulator auf einer ebenen Fläche des Substrats definiert sind,
**dadurch gekennzeichnet, dass**
der Wellenleiter derart konfiguriert ist, dass sich seine Höhe in einer Richtung senkrecht zu der ebenen Fläche des Substrats derart verjüngt, dass sie an der Zwischenposition kleiner ist als an Positionen auf jeder Seite der Zwischenposition entlang der Kopplungsachse.

## Revendications

1. Structure laser composite comprenant :
un substrat ; et
une structure de guide d'ondes active comprenant un émetteur laser défini sur une première zone du substrat et un modulateur optique défini sur une seconde zone du substrat, le modulateur étant couplé optiquement à l'émetteur laser le long d'un axe de couplage ;
la structure de guide d'ondes active étant configurée de telle sorte que sa section transversale perpendiculaire à l'axe de couplage diminue de façon à être plus petite à un emplacement intermédiaire entre l'émetteur laser et le modulateur optique qu'à des emplacements de part et d'autre de l'emplacement intermédiaire le long de l'axe de couplage, l'émetteur laser et le modulateur étant définis sur une face plane du substrat,
**caractérisé en ce que** le guide d'ondes actif est configuré de telle sorte que sa hauteur dans une direction perpendiculaire à la face plane du substrat diminue de façon à être plus petite à l'emplacement intermédiaire qu'à des emplacements de part et d'autre de l'emplacement intermédiaire le long de l'axe de couplage.

2. Structure laser composite selon la revendication 1, l'émetteur laser ayant une première extrémité plus éloignée du modulateur et une seconde extrémité plus proche du modulateur et l'émetteur laser étant configuré de sorte que sa section transversale diminue vers le modulateur dans la région de la seconde extrémité.

3. Structure laser composite selon la revendication 1 ou 2, le modulateur ayant une première extrémité plus éloignée de l'émetteur laser et une seconde extrémité plus proche de l'émetteur laser, et le modulateur étant configuré de sorte que sa section transversale diminue vers l'émetteur laser dans la région de la seconde extrémité.

4. Structure laser composite selon la revendication 3, lorsqu'elle est dépendante de la revendication 2, le cône dans le modulateur étant plus long que le cône dans l'émetteur laser.

5. Structure laser composite selon l'une quelconque des revendications précédentes, le guide d'ondes comprenant une région d'isolation électrique s'étendant entre l'émetteur laser et le modulateur.

6. Structure laser composite selon l'une quelconque des revendications précédentes,
le guide d'ondes étant configuré de telle sorte que sa largeur dans une direction perpendiculaire à l'axe de couplage et parallèle à la face plane du substrat diminue de manière à être plus petite à l'emplacement intermédiaire qu'à des emplacements de part et d'autre de l'emplacement intermédiaire le long de l'axe de couplage.

7. Structure laser composite selon l'une quelconque des revendications précédentes, le guide d'ondes conique étant opérationnel pour, lorsque la structure laser est en fonctionnement, favoriser, dans une région de la structure coïncidant axialement avec l'emplacement intermédiaire, la propagation dans le substrat d'un mode optique de lumière se déplaçant dans le guide d'ondes.

8. Structure laser composite selon l'une quelconque des revendications précédentes, le guide d'ondes diminuant de façon monotone vers l'emplacement intermédiaire.

9. Structure laser composite selon l'une quelconque des revendications précédentes, l'émetteur laser étant un laser à rétroaction distribuée, DFB.

10. Structure laser composite selon l'une quelconque des revendications précédentes, le modulateur optique étant configurable sous l'action d'un champ électrique appliqué pour sélectionner sa réponse en fréquence.

11. Structure laser composite selon l'une quelconque des revendications précédentes, le modulateur optique étant un modulateur à absorption électrique, EAM.

12. Structure laser composite selon l'une quelconque des revendications précédentes, comprenant une interface cristalline entre au moins une partie de l'émetteur laser et du modulateur optique, l'interface cristalline étant située à moins de 100 µm de l'emplacement intermédiaire dans une direction le long de l'axe de couplage.

13. Structure laser composite selon la revendication 12, l'interface cristalline étant une interface couplée bout à bout.

14. Procédé de formation d'une structure laser composite, comprenant :
la formation d'un premier élément parmi un émetteur laser et un modulateur optique sur un substrat ; et
le dépôt de l'autre élément parmi un émetteur laser et un modulateur optique sur le substrat de façon à être couplé bout à bout le long d'un axe de couplage au premier élément parmi un émetteur laser et un modulateur optique, et de façon à ce que l'émetteur laser et le modulateur optique définissent ensemble au moins partiellement une structure de guide d'ondes active ;
la structure de guide d'ondes active étant configurée de telle sorte que sa section transversale perpendiculaire à l'axe de couplage diminue de manière à être plus petite à un emplacement intermédiaire entre l'émetteur laser et le modulateur optique qu'à des emplacements de part et d'autre de l'emplacement intermédiaire le long de l'axe de couplage,
l'émetteur laser et le modulateur étant définis sur une face plane du substrat,
**caractérisé en ce que**
le guide d'ondes est configuré de telle sorte que sa hauteur dans une direction perpendiculaire à la face plane du substrat diminue de façon à être plus petite à l'emplacement intermédiaire qu'à des emplacements de part et d'autre de l'emplacement intermédiaire le long de l'axe de couplage.
